(19) **Europäisches Patentamt / European Patent Office / Office européen des brevets**

(11) **EP 4 729 961 A1**

(12) # EUROPEAN PATENT APPLICATION
published in accordance with Art. 153(4) EPC

(43) Date of publication:
**22.04.2026 Bulletin 2026/17**

(21) Application number: **24823114.4**

(22) Date of filing: **24.04.2024**

(51) International Patent Classification (IPC):
**G01R 31/382** (2019.01)   **G01R 31/00** (2006.01)
**H01M 10/48** (2006.01)

(52) Cooperative Patent Classification (CPC):
**G01R 31/00; G01R 31/382; H01M 10/48;**
**Y02E 60/10**

(86) International application number:
**PCT/JP2024/016090**

(87) International publication number:
**WO 2024/257492 (19.12.2024 Gazette 2024/51)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **14.06.2023 JP 2023097845**

(71) Applicant: **Hitachi, Ltd.**
**Tokyo 100-8280 (JP)**

(72) Inventor: **UEDA Suguru**
**Tokyo 100-8280 (JP)**

(74) Representative: **Mewburn Ellis LLP**
**Aurora Building**
**Counterslip**
**Bristol BS1 6BX (GB)**

(54) **DETERMINATION SYSTEM AND DETERMINATION METHOD**

(57) A determination system (100) comprises: a calculating unit (15) for calculating, from each set of time-series data including a DC current value and at least one value of a DC voltage value or an SOC of a secondary battery (210) during charging/discharging, which is at least one of charging and discharging of the secondary battery, spectrum information representing a spectrum in a two-axis coordinate system in which one axis represents a relaxation time and the other axis represents intensity; and a determining unit (16) which uses shape information relating to the shape of the spectrum calculated by the calculating unit (15) to determine a control condition of the secondary battery (210).

[FIG. 1]

## Description

### TECHNICAL FIELD

The present disclosure relates to a determination system and a determination method.

### BACKGROUND ART

In recent years, a secondary battery such as a lithium-ion battery is used as a power supply mounted in a ship, an aircraft, or a vehicle (railway, automobile, or the like) and as a power supply for power storage in a smart house, a smart grid, or the like to strengthen efforts toward efficient energy use. However, characteristics of the secondary battery rapidly degrade when the secondary battery is used in a wrong method. Accordingly, in order to continuously use a product equipped with the secondary battery for a long period, it is preferable to appropriately set a usage condition (control condition) of the secondary battery. Note that the rapid characteristic degradation of the secondary battery is referred to as "battery abnormality" below, and the battery abnormality is distinguished from degradation over time that occurs with normal usage.

A lithium disposition phenomenon can be given as an example of the battery abnormality. This is a degradation phenomenon that occurs in the case where the secondary battery is continuously used in conditions such as a condition of low temperature and large current value. In the lithium deposition phenomenon, metal lithium deposits on an electrode of the secondary battery, and this causes a capacity decrease, a resistance increase, and the like of the secondary battery. Moreover, if the lithium deposition phenomenon continues to progress, internal short-circuit of the secondary battery may eventually occur.

A study of analyzing a state inside a battery is performed to suppress the battery abnormality. For example, the abstract of Patent Literature 1 states that "provided is an analyzing device equipped with a battery condition analyzing unit which detects a change in the condition of constituent members of the battery on the basis of changes in a peak of a relaxation time in a prescribed frequency band".

### CITATION LIST

**Patent Literature**

Patent Literature 1: WO2017/179266

### SUMMARY OF INVENTION

**Technical Problem**

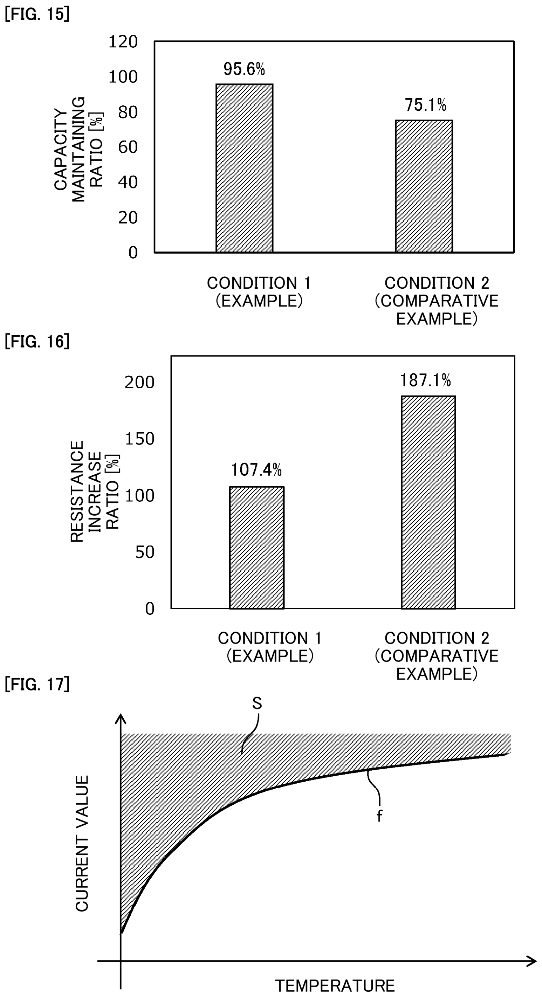

FIG. 17 is a schematic diagram explaining a threshold of each of a temperature and a current value at which the battery abnormality occurs. In order to reduce frequency of replacement, repair, and the like of the secondary battery caused by the battery abnormality, it is preferable to identify a condition in which the battery abnormality occurs and perform battery control such that usage of the secondary battery is avoided in this condition. For example, in order to suppress occurrence of the lithium deposition phenomenon, it may be to identify in advance a threshold of each of a temperature and a current value at which the lithium deposition phenomenon occurs. Specifically, the function f expressing these thresholds in, for example, FIG. 17 are determined through, for example, experiments, simulation, or the like. Then, the lithium deposition phenomenon can be suppressed by avoiding usage in the region S above the graph of the function f. That is, it is preferable to control the temperature, the current value, and the like of the secondary battery to avoid the region S.

Roughly speaking, two methods are known as methods for identifying the abnormality occurrence condition in the secondary battery. One method is a method of continuously using the secondary battery at a constant temperature and a constant current value for a long period to cause the secondary battery to degrade and determining whether the battery abnormality occurs in this process or not. This method is referred to as cycle degradation test, and the condition in which the battery abnormality occurs can be identified by executing the cycle degradation test at multiple temperature conditions and multiple current value conditions. Meanwhile, this method has such a problem that identification of the abnormality occurrence condition by the cycle degradation test takes a test period of about several months to several years, and it is difficult to quickly detect and take measures against an abnormality occurrence risk of the secondary battery by using this method.

The other method is a method of measuring a reaction current value (hereinafter, referred to as reaction mode) flowing in the secondary battery. When the secondary battery is used under a condition in which the battery abnormality occurs, the number of reaction modes measured in a charging-discharging process of the secondary battery changes. For example, in the case of a lithium deposition decrease, a reaction mode in which lithium ions deposit on an electrode surface occurs inside the secondary battery, in addition to a mode of an intercalation reaction of lithium ions into the electrode (reaction of normal battery). Accordingly, the number of reaction modes increases from that in a normal charging-discharging reaction. Specifically, whether the battery abnormality occurs or not under a usage condition of the secondary battery can be determined by focusing on a change in the number of reaction modes. Since the measurement of the number of reaction modes can be completed in a test of about several minutes, this method has such an advantage that the abnormality occurrence risk can be determined more quickly than the cycle degradation test.

An AC current value is used in the AC impedance method described in paragraph 0064 of Patent Literature 1 as a technique of measuring the number of reaction modes. However, a high AC current cannot be applied to the secondary battery. Meanwhile, in the secondary battery, the battery abnormality is significant when a large current is made to flow. Accordingly, the AC impedance method using the AC current cannot appropriately evaluate the battery abnormality of the secondary battery, and the control condition in which the battery abnormality can be suppressed cannot be appropriately determined.

A problem to be solved by the present disclosure is to provide a determination system and a determination method that can appropriately determine a control condition in which battery abnormality can be suppressed.

**Solution to Problem**

A determination system of the present disclosure includes: a calculating unit configured to calculate spectrum information expressing spectra in a two-axis coordinate system in which one axis represents a relaxation time and the other axis represents an intensity, from time series data of each of values including a DC current value and at least one of a DC voltage value or a SOC of a secondary battery in charging-discharging that is at least one of charging or discharging of the secondary battery; and a determining unit configured to determine a control condition of the secondary battery by using shape information relating to shapes of the spectra calculated by the calculating unit. Other solving means are described later in Description of Embodiments.

**Advantageous Effects of Invention**

The present disclosure can provide a determination system and a determination method that can appropriately determine a control condition in which battery abnormality can be suppressed.

**BRIEF DESCRIPTION OF DRAWINGS**

[FIG.1] FIG. 1 is a block diagram showing a determination system of the present disclosure.
[FIG.2] FIG. 2 is a map showing a calculation result of a relaxation spectrum for each temperature and each current value.
[FIG.3] FIG. 3 is a map showing a calculation result of a relaxation spectrum for each temperature and each voltage value in another embodiment.
[FIG.4] FIG. 4 is a map showing a calculation result of a relaxation spectrum for each voltage value and each current value in another embodiment.
[FIG.5] FIG. 5 is a diagram showing an example of the relaxation spectrum.
[FIG.6] FIG. 6 is a block diagram showing the determination system according to another embodiment.
[FIG.7] FIG. 7 is a block diagram showing the determination system according to another embodiment.
[FIG.8] FIG. 8 is a block diagram showing the determination system according to another embodiment.
[FIG.9] FIG. 9 is a block diagram showing a hardware configuration of the determination system.
[FIG.10] FIG. 10 is a flowchart showing a determination method of the present disclosure.
[FIG.11] FIG. 11 is a map that is obtained by actually performing evaluation tests and that is used to obtain an occurrence condition of battery abnormality from the relaxation spectra.
[FIG.12] FIG. 12 is a map that is obtained by actually performing evaluation tests and in which a range in which the battery abnormality occurs is excluded.
[FIG.13] FIG. 13 is a photograph capturing an electrode surface of a secondary battery used in Condition 1 (Example).
[FIG.14] FIG. 14 is a photograph capturing the electrode surface of the secondary battery used in Condition 2 (Comparative Example).
[FIG.15] FIG. 15 is a verification result showing a difference in a battery capacity between the secondary battery used in Condition 1 (Example) and the secondary battery used in Condition 2 (Comparative Example).

**[FIG.16]** FIG. 16 is a verification result showing a difference in an internal resistance between the secondary battery used in Condition 1 (Example) and the secondary battery used in Condition 2 (Comparative Example).

**[FIG.17]** FIG. 17 is a schematic diagram explaining a threshold of each of a temperature and a current value at which the battery abnormality occurs.

## DESCRIPTION OF EMBODIMENTS

A mode for carrying out the present disclosure (referred to as embodiment) is explained below with reference to the drawings. In the following explanation of one embodiment, other embodiments that can be applied to the one embodiment are also explained as necessary. The present disclosure is not limited to the following one embodiment, and can be combined with different embodiments or modified as desired within a range in which effects of the present disclosure are not significantly impaired. Moreover, the same members are denoted by the same reference numerals, and overlapping explanation is omitted. Furthermore, the same names are given to members with the same functions. Contents of illustration are merely schematic. The contents may be changed from actual configurations, and illustration of some of members may be omitted or deformed among the drawings within a range in which the effects of the present disclosure are not significantly impaired, for convenience of illustration. Moreover, not all of configurations have to be included in the same embodiment.

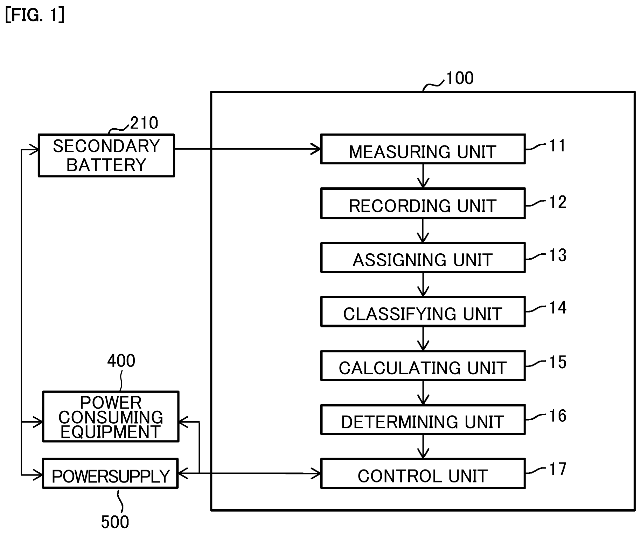

FIG. 1 is a block diagram showing a determination system 100 of the present disclosure. Hereinafter, the determination system 100 and a secondary battery 210 as a whole are referred to as battery system 300. Accordingly, the battery system 300 includes the determination system 100 and the secondary battery 210. The determination system 100 is a system that determines a control condition (charging-discharging condition) of the secondary battery 210 in which occurrence of battery abnormality in the secondary battery 210 is suppressed. The battery abnormality is abnormality different from degradation over time that occurs with normal usage, and is, for example, a lithium deposition phenomenon on an electrode surface as described above, but is not limited to this.

A power consuming equipment 400 such as, for example, a motor or an inverter and a power supply 500 are connected to the secondary battery 210. The power supply 500 charges the secondary battery 210. The power consuming equipment 400 is driven by power generated by discharging of the secondary battery 210. Accordingly, at least one of the charging or the discharging (preferably both. These are collectively referred to as charging-discharging below) is performed according to the control condition determined by the determination system 100.

The control condition of the secondary battery 210 includes at least one of, for example, a DC current value during the charging-discharging, a DC voltage value during the charging-discharging, or a temperature of the secondary battery 210. Hereinafter, the DC current value, the DC voltage value, and the temperature of the secondary battery are simply referred to as current value, voltage value, temperature, and the like as appropriate unless otherwise noted. The secondary battery 210 is, for example, a lithium-ion secondary battery, but may be another type of secondary battery such as, for example, a lead battery or a nickelcadmium battery.

The determination system 100 includes a measuring unit 11, a recording unit 12, an assigning unit 13, a classifying unit 14, a calculating unit 15, a determining unit 16, and a control unit 17. All of these units may be configured to be included in one body, or at least some of the units may be configured as a separate body. In the case where all of these units are configured to be included in one body, the determination system 100 can be referred to as determination apparatus. Meanwhile, in the case where at least some of the units are configured as a separate body, for example, these some units may be housed in, for example, a server (not shown) installed in a remote location via a network.

The measuring unit 11 is a unit that measures time series data of each of values including the DC current value and at least one of the DC current voltage value or a SOC of the secondary battery 210 during the charging-discharging that is at least one of the charging or the discharging of the secondary battery 210. That is, the time series data includes time series data of the DC current value and j series data of at least one of the DC voltage value or the SOC of the secondary battery 210. The measurement is performed constantly or at predetermined time intervals (for example, every one minute or the like) during usage including of the charging-discharging of the secondary battery 210, standby in which no charging-discharging is performed, or the like. Since there is a correlation between the DC voltage value and the SOC, in the following explanation, the measuring unit 11 measures the time series data relating to the DC voltage value as an example. However, the measuring unit 11 may measure the time series data of the SOC. Moreover, in the example of the present disclosure, the time series data further includes time series data of the temperature of the secondary battery 210.

The measuring unit 11 extracts the time series data in a period (timing) in which a relaxation spectrum can be calculated, from collection of the measured time series data (so-called "raw data"). The relaxation spectrum is a spectrum (charging-discharging spectrum) that is a continuous function of relaxation time and that is a spectrum in a two-axis coordinate system in which one axis (for example, horizontal axis) represents the relaxation time and the other axis (for example, vertical axis) represents intensity (spectrum intensity). In the extraction, it is preferable to extract the time series data in each of at least one of periods of, for example, during constant voltage charging, after charging, or after discharging. After charging may be after constant voltage charging or after constant current charging. After discharging may be after constant voltage discharging or after constant current discharging. Moreover, it is preferable that multiple pieces of time series data extracted from various periods are present.

When the time series data during the constant voltage charging is to be extracted, the measuring unit 11 extracts the time series data of each of the voltage value, the current value, and the temperature of the secondary battery 210 from a time point t1 of start of the constant voltage charging to a time point t2 of end of the constant voltage charging. The "constant voltage charging" is a charging method in which the secondary battery 210 is charged while being maintained at a constant voltage value. Furthermore, the measuring unit 11 also extracts a voltage value before (preferably, immediately before) the start of charging of the secondary battery 210. Although a time from the time point t1 to the time point t2 is not limited to a certain time, the time is preferably one minute or more and 30 minutes or less, more preferably 10 minutes or more and 20 minutes or less.

When the time series data after charging (after end of charging) or after discharging (after end of discharging) is to be extracted, the measuring unit 11 extracts the time series data of each of the voltage value, the current value, and the temperature of the secondary battery 210 from a time point t3 of end of the charging or the discharging to a predetermined time point t4. Furthermore, the measuring unit 11 also obtains a current value immediately before the end of charging or discharging of the secondary battery 210. Although a time from the time point t3 to the time point t4 is not limited to a certain time, the time is preferably one minute or more and 30 minutes or less, more preferably 10 minutes or more and 20 minutes or less.

A method in which the measuring unit 11 obtains measurement data (data including the above-mentioned time series data, the voltage value before start of charging, the current value immediately before the charging-discharging, and the like) from the secondary battery 210 is not limited to a certain method. For example, the measuring unit 11 may be configured to measure data (for example, measurement data) relating to the secondary battery 210 at a location different from an installed location of the secondary battery 210. This allows, for example, the measurement data of the secondary battery 210 to be centrally managed in, for example, a server (not shown) arranged at a remote location when the secondary battery 210 is installed in, for example, a vehicle, a ship, an aircraft, or the like. This can improve usability.

Specifically, for example, the measuring unit 11 may obtain the measurement data from the secondary battery 210 via a communication circuit such as an electric circuit or a wired LAN, obtain the measurement data from the secondary battery 210 placed at a remote location via a network such as a wireless LAN, or obtain the measurement data in a method combining the above-mentioned obtaining methods. Moreover, the measuring unit 11 may obtain the measurement data via another apparatus in a process of obtaining the measurement data from the secondary battery 210. For example, the measuring unit 11 may obtain the measurement data from the secondary battery 210 via an external apparatus (not shown) such as a charging-discharging apparatus. Moreover, the measuring unit 11 may be configured such that the measurement data obtained from the secondary battery 210 is stored in a server (not shown), and the measuring unit 11 obtains the stored measurement data.

The recording unit 12 is a unit that saves the measurement data (data including the above-mentioned time series data, the voltage value before the start of charging, the current value immediately before the charging-discharging, and the like) of the secondary battery 210 extracted by the measuring unit 11. Note that each piece of measurement data is preferably saved while being classified according to a timing at which the data is extracted. For example, assume a case where there are measurement data $D_{AB}$ extracted in a period from a time point tA to a time point tB and measurement data $D_{CD}$ extracted in a period from a time point tC to a time point tD. In this case, the measurement data $D_{AB}$ and the measurement data $D_{CD}$ are preferably not saved together, but saved individually in the recording unit 12 while being associated with the obtained periods (for example, from the time point tA to the time point tB, from the time point tC to the time point tD, and the like).

The assigning unit 13 is a unit that assigns a label to each spectrum calculated from the time series data obtained between different time points according to a predetermined rule using at least two of the DC current value, the DC voltage value, or the temperature. Providing the assigning unit 13 enables creation of a map (to be described later) including multiple relaxation spectra, from the time series data obtained based on the various times points and various types (separately for current value, voltage value, or temperature).

In the example of the present disclosure, the assigning unit 13 refers to the measurement data saved in the recording unit 12, and calculates a representative value (example of label) of each of the current value, the voltage value, and the temperature. The calculated representative values are assigned to the calculated relaxation spectrum and the measurement data used for calculation of the relaxation spectrum. As described in detail later, the relaxation spectrum is calculated based on the time series data measured in different periods. Moreover, the calculated relaxation spectrum is associated with the representative values.

When multiple pieces of measurement data extracted at different timings are saved in the recording unit 12, the assigning unit 13 calculates the representative values for each piece of measurement data. Specifically, for example, when there are the measurement data $D_{AB}$ extracted in the period from the time point tA to the time point tB and the measurement data $D_{CD}$ extracted in the period from the time point tC to the time point tD, the assigning unit 13 calculates the representative values for each of the measurement data $D_{AB}$ and the measurement data $D_{CD}$.

A calculation method of the representative values (determination method of labels) is not limited a particular method as long as the representative values can be calculated according to the same predetermined rule irrespective of the type and the period of the time series data. Two examples showing the calculation method of the representative values are described below.

<Calculation Method 1 of Representative Values: Case Where Representative Values are Calculated from Measurement Data during Constant Voltage Charging>

For example, a current value immediately after the start of constant voltage charging can be adopted as the representative value of the current value. Moreover, an average voltage value during the constant voltage charging can be adopted as the representative value of the voltage value. Furthermore, an average value of the time series data of the measured temperature can be adopted as the representative value of the temperature.

<Calculation Method 2 of Representative Value: Case Where Representative Values are Calculated from Measurement Data after Charging or after Discharging>

For example, a current value immediately before the end of charging or immediately before the end of discharging can be adopted as the representative value of the current value. Moreover, a voltage value immediately before the end of charging or immediately after the end of discharging can be adopted as the representative value of the voltage value. Furthermore, an average value of the time series data of the recorded temperature can be adopted as the representative value of the temperature.

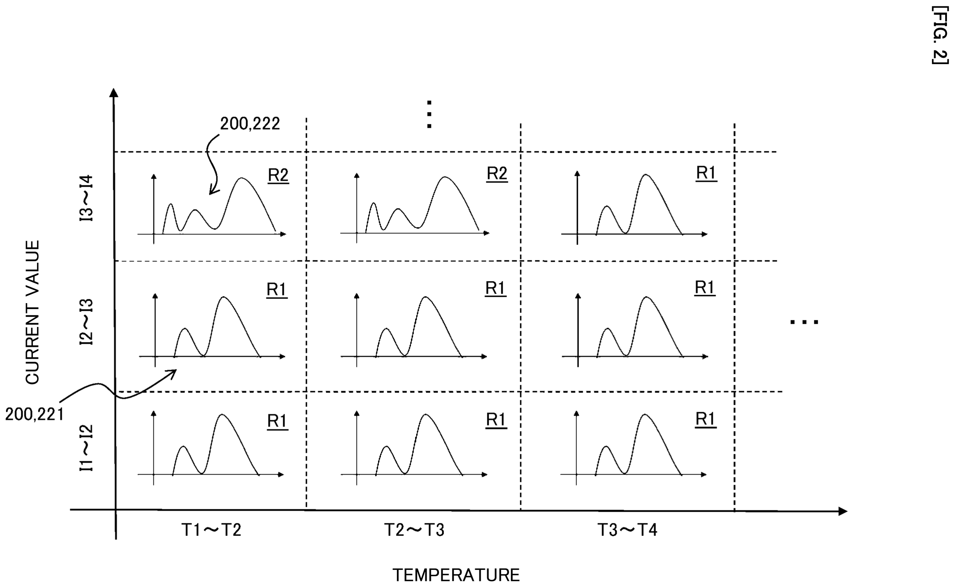

The classifying unit 14 is a unit that classifies the relaxation spectra to which the labels are assigned, according to the assigned labels such that the relaxation spectra are associated with conditions of at least two of the current value (DC current value), the voltage value (DC voltage value), or the temperature. Providing the classifying unit 14 enables creation of a map (to be described later) including multiple relaxation spectra, from the time series data obtained based on various time points and various types. Specific contents of the map are described later with reference to, for example, FIG. 2 and the like.

The conditions herein are each configured to include numerical ranges. Accordingly, the relaxation spectrum is associated with one of the multiple numerical ranges forming each of the conditions, for at least two of the conditions of, for example, a range of the current value, a range of the voltage value, and a range of the temperature.

In the example of the present disclosure, the classifying unit 14 classifies each piece of measurement data accumulated in the recording unit 12 by using a control condition (usage condition) assumed in usage of the secondary battery 210 and the representative values assigned by the assigning unit 13. The control condition includes usage ranges, respectively, of the current value, the voltage value, and the temperature assumed in, for example, charging-discharging of the secondary battery 210. The control condition can be determined in advance based on, for example, usage application of the secondary battery 210.

As a specific classification method, for example, the classifying unit 14 divides the control condition of the secondary battery 210 into an infinite number of sections. For example, when the secondary battery 210 is assumed to be used in a temperature range of $T_{min}$ to $T_{max}$ ($T_{min}<T_{max}$), the classifying unit 14 divides the temperature range into N sections such as $T_{min}$ to $T_1$, $T_1$ to $T_2$, $T_2$ to $T_3$, ..., and $T_{N-1}$ to $T_{max}$. N is an integer of 1 or more. The classifying unit 14 also similarly divides an assumed usage range of each of the current value and the voltage value of the secondary battery 210 into an infinite number of sections in a similar way. Note that the usage condition of the secondary battery 210 may be registered in advance in the calculating unit 15 (described later), or may be determined based on the measurement data of the secondary battery 210 obtained by the measuring unit 11. When the usage condition is determined based on the measurement data, for example, in the case of the temperature, the minimum value and the maximum value in, for example, the collection of the measured time series data (raw data) can be set as $T_{min}$ and $T_{max}$, respectively.

Next, the classifying unit 14 selects one of the above-mentioned sections to which the representative value assigned to the time series data or the like by the assigning unit 13 corresponds. The time series data and the like saved in the recording unit 12 are thereby classified according to the section. When multiple pieces of time series data or the like extracted at different timings are saved in the recording unit 12 as described above, the classification is performed for each piece of time series data or the like.

When multiple pieces of data measured at different timings are assigned to the same section as a result of the classification, the classifying unit 14 processes the time series data such that the number of time series data for each of the current value, the voltage value, and the temperature is determined to be one. One relaxation spectrum is thereby associated with one numerical range. The numeral range herein is a numerical range included in the conditions of at least two of the current value, the voltage value, or the temperature as described above. For example, in the case of temperature, the temperature range is one of $T_{min}$ to $T_1$, $T_1$ to $T_2$, $T_2$ to $T_3$, ..., and $T_{N-1}$ to $T_{max}$.

As a processing method, for example, only the data obtained in the latest time may be adopted. Moreover, a result obtained by averaging all pieces of data assigned to the same section may be adopted. Specifically, for example, when there are multiple pieces of time series data of the current value, time series data of an average current value can be created by obtaining an average of all pieces of time series data of the current value.

The calculating unit 15 is a unit that calculates spectrum information expressing each of the above-mentioned relaxation spectra (example of spectra). The spectrum information may be a graph expressing the relaxation spectrum, a function expressing the relaxation spectrum, or a shape of the relaxation spectrum. For example, the shape may include at least one of the number of peaks included in the relaxation spectrum, the position of the peak, the area of the peak, the half-value width of the peak, the skewness of the peak, or the like. The spectrum information may be character information (for example, numerical value) or information other than the character information (for example, shape).

The calculating unit 15 calculates the relaxation spectrum from the time series data in each of at least one of the periods including during constant voltage charging, after charging, or after discharging. The relaxation spectrum can be calculated by using these pieces of time series data. A specific calculation method is as described below, but the calculation method is not limited to the following example.

<Calculation Method 1: Case Where Relaxation Spectrum is Calculated from Measurement Data during Constant Voltage Charging>

In this case, a relaxation spectrum $\rho(\tau)$ can be calculated from Formula (1) by using the measurement data.
[Math 1]

$$\rho(\tau) = \mathcal{L}^{-1}(I(t) / \Delta V) \quad \ldots \text{Formula (1)}$$

$\rho(\tau)$ is the relaxation spectrum, $\Delta V$ is a difference between a battery voltage value before (preferably immediately before) the start of charging and the voltage value in the constant voltage charging, and $I(t)$ is the time series data of the current value during the constant voltage charging. Moreover, a sign $L^{-1}$ (inverse number of capital L described in cursive) indicates inverse Laplace transformation on $I(t)/\Delta V$.

<Calculation Method 2: Case Where Relaxation Spectrum is Calculated from Measurement Data after Charging or after Discharging>

In this case, the relaxation spectrum $\rho(\tau)$ can be calculated from Formula (2) described below by using the measurement data.
[Math 2]

$$\rho(\tau) = \mathcal{L}^{-1}(V(t) / I_0) \quad \ldots \text{Formula (2)}$$

$\rho(\tau)$ is the relaxation spectrum, $I_0$ is the current value immediately before the end of charging or immediately before the end of discharging, and $V(t)$ is the time series data of the voltage value after the charging or after the discharging. Moreover, the sign $L^{-1}$ (inverse number of capital L described in cursive) indicates inverse Laplace transformation on $V(t)/I_0$.

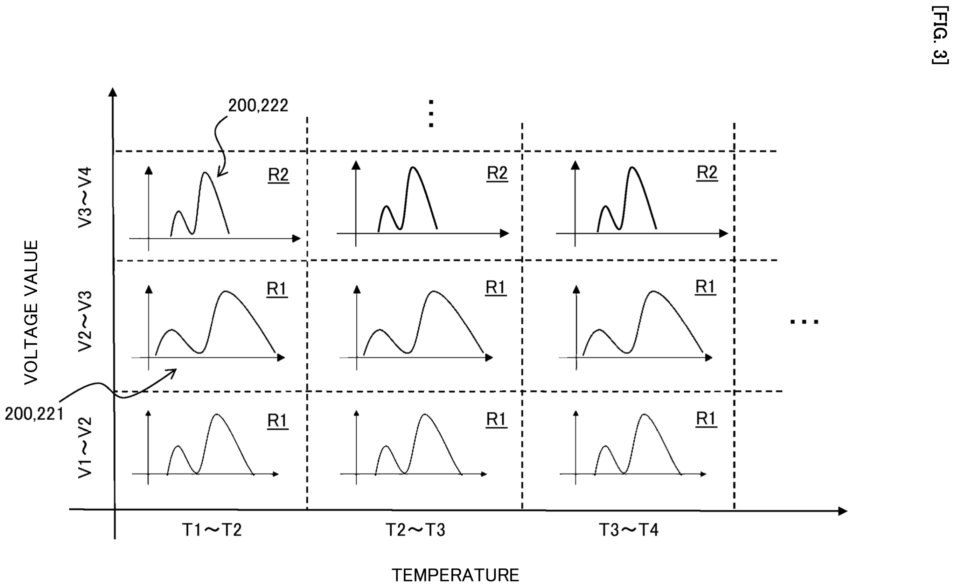

FIG. 2 is a map showing a calculation result of the relaxation spectrum for each temperature and each current value. FIG. 2 shows an example in which the temperature is divided into T1 to T2, T2 to T3, and T3 to T4 (each being a numerical value range) and the current value is divided into I1 to I2, I2 to I3, and I3 to I4 (each being a numerical value range) as an example. Moreover, in each of the nine relaxation spectra shown in FIG. 2, the horizontal axis represents the relaxation time, and the vertical axis represents the intensity of the spectrum, though description is omitted for simplification of illustration. The same applies to FIGs. 3, 4, 11, and 12 to be described later.

As described above, the calculating unit 15 (FIG. 1) calculates the relaxation spectrum for each of the sections of the temperature and the current value by using the time series data or the like classified into each section by the classifying unit 14 (FIG. 1). Accordingly, for example, the relaxation spectrum calculated by using the time series data or the like sectioned to the temperature T1 to T2 and the current value I1 to I2 as a result of sectioning is classified (stored) into an item of the temperature T1 to T2 and the current value I1 to I2. Classifying each relaxation spectrum into corresponding one of items by using the corresponding time series data or the like enables obtaining of, for example, the map (relaxation spectrum map) shown in FIG. 2.

For example, as shown in FIG. 2, the relaxation spectra are associated with the temperature of the secondary battery 210. The current value and the voltage value at which occurrence of the battery abnormality can be suppressed may vary depending on the temperature of the secondary battery 210. That is, even at the same current value and the same voltage value, likeliness of occurrence of the battery abnormality may vary if the temperature of the secondary battery 210 varies. Accordingly, it is possible to more effectively suppress the battery abnormality of the secondary battery 210 by determining the control condition while also taking the temperature of the secondary battery 210 into consideration. Note that, for example, the temperature of the secondary battery 210 is predictable to some extent depending on an installation environment of the secondary battery 210. Moreover, the secondary battery 210 is sometimes used in temperature, application, and the like in which the battery abnormality is unlikely to occur in the first place. Accordingly, in such cases, the temperature does not have to be taken into consideration.

Moreover, the relaxation spectra classified into the respective items are preferably based on the pieces of time series data or the like measured in different periods. Note that the periods herein are periods in which a starting point is reset every time the secondary battery 210 is replaced, repaired, or the like. Moreover, in FIG. 2, relaxation spectra 200 preferably include, for example, a first relaxation spectrum 221 calculated from time series data from a first time point to a second time point and a second relaxation spectrum 222 calculated from time series data from a third time point to a fourth time point. Including multiple relaxation spectra 200 enables determination of the control condition in which the battery abnormality occurs, based on a shape change of the relaxation spectrum as described in detail later.

FIG. 3 is a map showing a calculation result of a relaxation spectrum for each temperature and each voltage value in another embodiment. FIG. 3 shows an example in which the temperature is divided into T1 to T2, T2 to T3, and T3 to T4 (each being a numerical value range) and the voltage value is divided into V1 to V2, V2 to V3, and V3 to V4 (each being a numerical value range) as an example.

In the example shown in FIG. 3, a first range R1 is a range in which the temperature is T1 to T4 and the voltage value is V1 to V3. Meanwhile, a second range R2 is a range in which the temperature is T1 to T4 and the voltage value is V3 to V4. Half-value widths of peaks of the second relaxation spectrum 222 included in the second range R2 are larger than half-value widths of peaks of the first relaxation spectrum 221 included in the first range R1.

As described above, the time series data of the present disclosure relates to the current value (FIG. 2), the voltage value, and the temperature. Accordingly, FIG. 2 described above shows the map relating to the current value and the temperature that are two of these items. However, the map is not limited to the map relating to the current value and the temperature, and may be the map relating to the voltage value and the temperature shown in FIG. 3. The map of FIG. 3 can be created as in the embodiment of FIG. 2 described above, except for the point that the time series data relating to the voltage value is used instead of the current value.

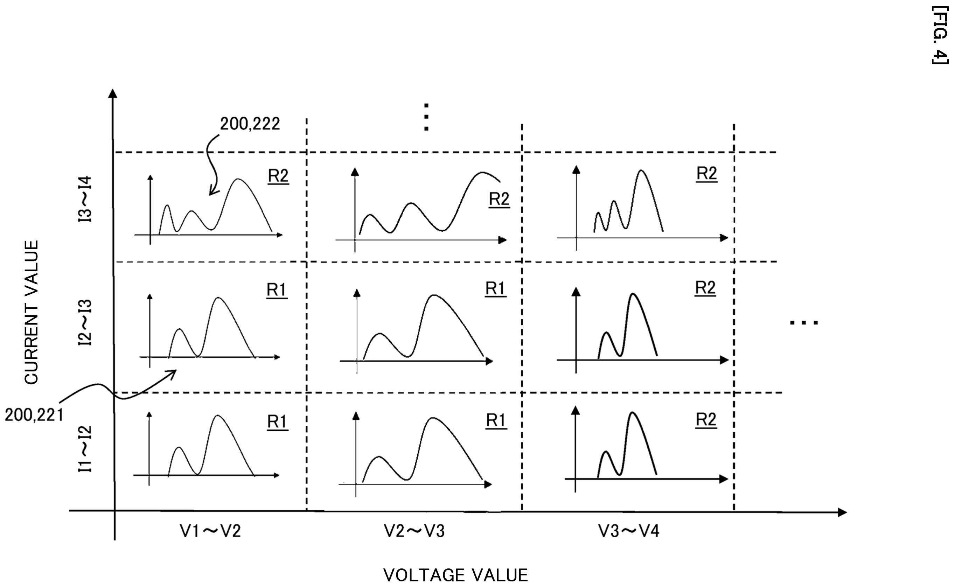

FIG. 4 is a map showing a calculation result of a relaxation spectrum for each voltage value and each current value in another embodiment. FIG. 4 shows an example in which the voltage value is divided into V1 to V2, V2 to V3, and V3 to V4 (each being a numerical value range) and the temperature is divided into T1 to T2, T2 to T3, and T3 to T4 (each being a numerical value range) as an example.

In the example shown in FIG. 4, the first range R1 is a range in which the voltage value is V1 to T3 and the current value is I1 to I3. Meanwhile, the second range R2 is a range in which the voltage value is V3 to V4 and the current value is I1 to I4 and a range in which the voltage value is V1 to V4 and the current value is I3 to I4. Half-value widths of peaks of the second relaxation spectrum 222 included in the range (second range R2) in which the voltage value is V3 to V4 and the current value is I1 to I4 are larger than half-value widths of peaks of the first relaxation spectrum 221 included in the first range R1. Moreover, the number of peaks of the second relaxation spectrum 222 included in the range (second range R2) in which the voltage value is V1 to V4 and the current value is I3 to I4 is larger than the number of peaks of the first relaxation spectrum 221 included in the first range R1.

As described above, the time series data of the present disclosure relates to the current value, the voltage value, and the temperature (FIG. 2). Accordingly, the map is not limited to the examples of FIGs. 2 and 3 described above, and may be the map relating to the voltage value and the current value shown in FIG. 4. The map of FIG. 4 can be created as in the embodiment of FIG. 2 described above, except for the point that the time series data relating to the voltage value is used instead of the temperature.

In the example of the present disclosure, for example, the three maps shown in FIGs. 2 to 4 can be constructed based on, for example, the pieces of time series data, respectively, of the current value, the voltage value, and the temperature. Then, more accurate control condition can be determined by using the three maps. Particularly, control conditions varying among the maps may be determined due to an effect of a measurement error or the like. In this case, for example, a condition with the smallest load (for example, the lowest current value or the lowest voltage value in the case of the current value or the voltage value) on the secondary battery 210 or a control condition common among the maps may be adopted as the control condition.

Returning to FIG. 1, the determining unit 16 is a unit that determines the control condition of the secondary battery 210 by using shape information relating to the shapes of the relaxation spectra calculated by the calculating unit 15. The determined control condition is the control condition of the secondary battery 210 in which occurrence of the battery abnormality in the secondary battery 210 can be suppressed as described above, and is, for example, the current value, the voltage value, and the temperature in the charging-discharging.

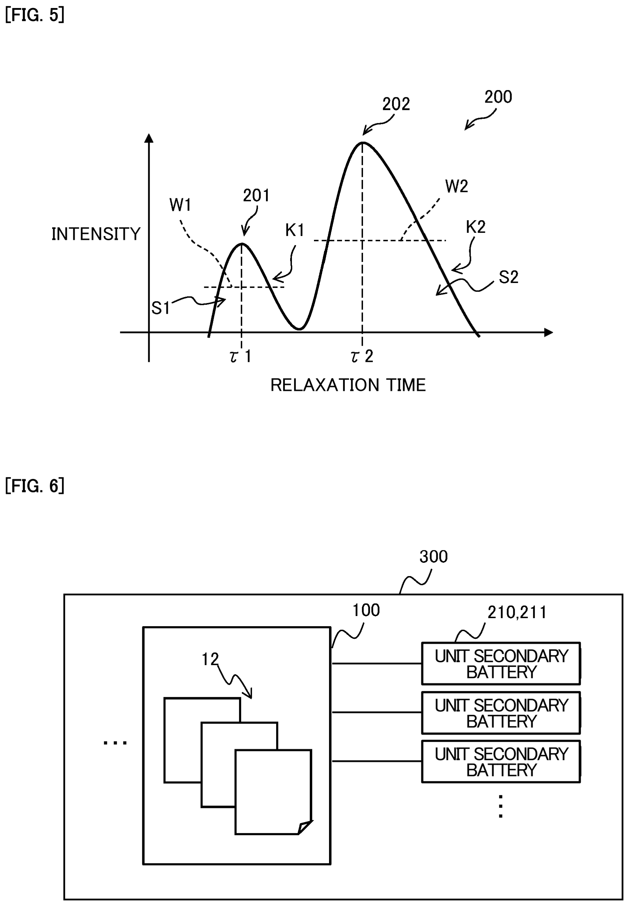

FIG. 5 is a diagram showing an example of the relaxation spectrum 200. The relaxation spectrum 200 shown in FIG. 5 includes two peaks 201 and 202. Moreover, the positions of the peaks 201 and 202 are relaxation times $\tau1$ and $\tau2$. The areas of the peaks 201 and 202 are S1 and S2. The half-value widths of the peaks 201 and 202 are W1 and W2. The skewnesses of the peaks 201 and 202 are K1 and K2.

The shape information used by the determining unit 16 preferably includes an index that can be quantified. Specifically, for example, the shape information preferably includes at least one of the number of peaks 201 and 202 in the relaxation spectrum 200, the positions of the peaks 201 and 202, the areas of the peaks 201 and 202, the half-value widths of the peaks 201 and 202, or the skewnesses of the peaks 201 and 202. Since these are all indices that can be quantified, an occurrence probability of abnormal degradation can be determined by using objective indices in the case where determination of the battery abnormality is performed as described in detail later.

The determining unit 16 (FIG. 1) is further explained with reference to FIG. 2 described above. Focusing on the number of peaks in each of the nine relaxation spectra shown in FIG. 2, in the second range R2 satisfying the temperature of T1 to T3 and the current value of I3 to I4, the number of peaks is three, unlike the number of peaks (two) in the first range R1 that is another range. That is, from the viewpoint of the first range R1 other than the second range R2 satisfying the temperature of T1 to T3 and the current value of I3 to I4, the number of peaks increases from that in the first range R1 to that in the second range R2. Note that the first range is the range of the temperature T1 to T4 and the current value I1 to I3, and the range of the temperature T3 to T4 and the current value I3 to I4.

As described above, the shape information of each relaxation spectrum corresponds to occurrence of a reaction mode inside the secondary battery 210. Accordingly, the change in the shape of the relaxation spectrum (for example, an increase in the number of peaks or the like) indicates occurrence of a moving reaction mode. Accordingly, the determining unit 16 determines the control condition based on, for example, a shape change from the first relaxation spectrum 221 classified into the first range R1 to the second relaxation spectrum 222. Since the control condition in which the battery abnormality occurs can be thereby determined, the control condition in which occurrence of the battery abnormality can be suppressed can be determined.

As described above, the number of peaks 201 and 202 in the relaxation spectrum 200, the positions of the peaks 201 and 202, the areas of the peaks 201 and 202, the half-value widths of the peaks 201 and 202, and the skewnesses of the peaks 201 and 202 are all indices that can be quantified. Accordingly, when the shape of the relaxation spectrum changes, changes of these indices can be expressed as "change amounts" that are numerical values.

Moreover, when the shape of the relaxation spectrum changes such that an index such as, for example, the number of peaks changes in a positive direction, the determining unit 16 determines that the battery abnormality occurs in the secondary battery 210. For example, in the case where the index is the number of peaks, the number of peaks changes from two (first range R1) to three (second range R2) in the positive direction (+1) as described above. Accordingly, the determining unit 16 determines that the battery abnormality occurs at the temperature and the current value of the second range R. Moreover, in the case where the index is the position of each peak, although illustration is omitted, it can be said that the relaxation time changed in the positive direction when the relaxation time indicating the position of the corresponding peak changes, for example, from $\tau1$ to $\tau2$ ($\tau1<\tau2$) between the relaxation spectra, respectively, of the first range R1 and the second range R2.

In the case where the index is the area of each peak, although illustration is omitted, it can be said that the area changed in the positive direction when the area of the corresponding peak changes, for example, from S1 to S2 (S1<S2) between the relaxation spectra, respectively, of the first range R1 and the second range R2. The area of each peak can be calculated according to any method. In the case where the index is the half-value width of each peak, although illustration is omitted, it can be said that the half-width value changed in the positive direction when the half-value width of the corresponding peak changes, for example, from W1 to W2 (W1<W2) between the relaxation spectra, respectively, of the first range R1 and the second range R2. The half-value width of each peak can be calculated according to any method. In the case where the index is the skewness of each peak, although illustration is omitted, it can be said that the skewness changed in the positive direction when the skewness of the corresponding peak changes, for example, from K1 to K2 (K1<K2) between the relaxation spectra, respectively, of the first range R1 and the second range R2. The skewness of each peak can be calculated according to any method.

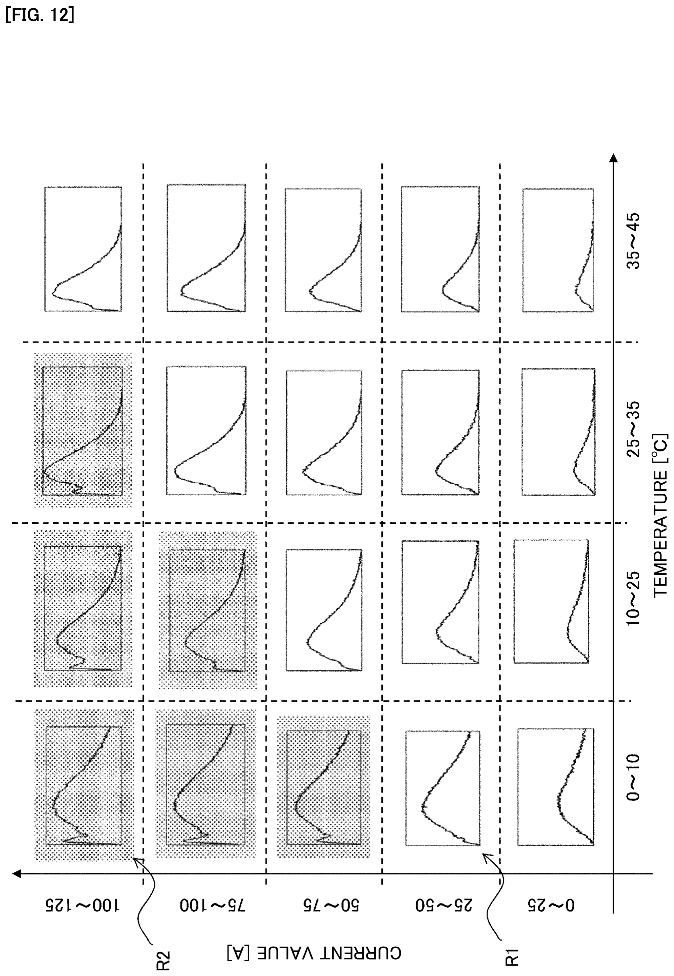

Note that it can be determined that potential abnormality does not occur in some cases even when, for example, the area, the half-width value, the skewness, or the like changed in the positive direction (increased) as shown in FIG. 12 described later. The configuration may be such that a threshold for the change amount is determined in advance for each of quantifiable indices, and when a change amount exceeding this threshold occurs, it can be determined that the battery abnormality occurs. Such a threshold can be determined through, for example, experiments, simulation, test drive, or the like. Moreover, the determination may be performed by using multiple indices to improve determination accuracy.

Then, the determining unit 16 determines the control condition such that the change for which the battery abnormality is determined to occur in the secondary battery 210 is excluded. In specific explanation according to FIG. 2, for example, the determining unit 16 determines that the battery abnormality occurs in the second region R2 in which, for example, the number of peaks or the like increases from that in the first range R1, that is the number of peaks changes in the performance direction in the map shown in FIG. 2. The determining unit 16 thereby determines the temperature and the current value corresponding to the second range R2 as the condition in which the battery abnormality occurs in the secondary battery 210. This allows control of the secondary battery 210 while avoiding occurrence of the battery abnormality.

Moreover, the determining unit 16 determines a current value lower than an abnormal current value corresponding to the relaxation spectrum for which the battery abnormality is determined to occur in the secondary battery 210, a voltage value lower than an abnormal voltage value corresponding to this relaxation spectrum, a temperature lower than an abnormal temperature corresponding to this relaxation spectrum, as the control condition. This can suppress occurrence of the battery abnormality.

The control unit 17 is a unit that performs charging-discharging control of the secondary battery 210 according to the determined control condition of the secondary battery 210. This can effectively suppress the battery abnormality of the secondary battery 210. In the example of the present disclosure, the control unit 17 controls the charging-discharging of the secondary battery 210 to suppress usage frequency of the secondary battery 210 in the occurrence condition (second range R2 (FIG. 2)) of the battery abnormality set by the determining unit 16. The charging-discharging control is performed by controlling the current value, the voltage value, and the temperature. Note that the control unit 17 does not completely prohibit the usage in the second range R2, and it is only necessary that the usage in the second range R2 can be suppressed from that in the case where the determination system 100 of the present disclosure is not used. Note that, for example, a cooling mechanism such as a liquid cooling device or an air-cooling device such as a fan can be used for the temperature control of the secondary battery 210.

The secondary battery 210 to which the present disclosure can be applied includes any form such as, for example, a secondary battery cell, a secondary battery module, a secondary battery pack, or a secondary battery system. Moreover, the secondary battery 210 may be mounted in an electric mobility such as, for example, a ship, an aircraft, or a vehicle (battery electric railcar, electric automobile, and the like), or may be mounted in a stationary storage battery system, and application of the secondary battery 210 may be changed during usage. For example, it can be applied to the case where the secondary battery 210 used in an electric mobility is reused as a stationary storage battery system.

Moreover, the present disclosure can be applied irrespective of a degradation state of the secondary battery 210. For example, the secondary battery 210 may either be a brand-new (undegraded state) battery or a battery in a degraded state (for example, used battery. Second-hand) by being used in a certain application. Moreover, the secondary battery 210 may be a secondary battery 210 that has degraded over time as a result of being not used for a long period.

Furthermore, the present disclosure can be also applied to control for achieving longevity, degradation suppression, and the like of the secondary battery 210 during usage, in addition to the application of suppressing occurrence of the battery abnormality in the secondary battery 210.

Moreover, the present disclosure can be used to determine a usage application suiting each of the brand-new secondary battery 210 and the second-hand secondary battery 210. A method of this determination is described below.

First, the secondary battery 210 is connected to a charging-discharging apparatus (not shown), and is charged and discharged under a control condition of the current value, the voltage value, and the temperature set in advance. The time series data in this case is used to calculate relaxation spectra according to the above-mentioned method. Then, the calculated relaxation spectra are used to determine a control condition including at least two of the current value, the voltage value, or the temperature at which the battery abnormality does not occur.

Next, the current value, the voltage value, and the temperature at which the secondary battery 210 is to be used in an application in which the secondary battery 210 is expected to be used are evaluated. For example, in the case of an electric automobile, the current value and the voltage value of the secondary battery 210 used in vehicle travel are obtained based on performances of a motor and an inverter, and the temperature of the secondary battery 210 is estimated from Joule heat generated in this case. As described above, whether the current value, the voltage value, and the temperature obtained based on the expected application of the secondary battery 210 fit into the current value, the voltage value, and the condition obtained from the relaxation spectra or not is evaluated. Whether the secondary battery 210 is suitable for the expected usage application or not can be thereby determined.

Moreover, the determination of the control condition by the determination system 100 may be performed at any timing. For example, the control condition may be determined in factory shipment of a product equipped with the secondary battery 210, in maintenance of this product, or the like. Then, the control in the following operation and beyond can be performed according to the determined control condition.

Moreover, for example, when the determination system 100 and the secondary battery 210 are constantly connected to each other via a network, the determination system 100 arranged at a remote location may constantly monitor the state of the secondary battery 210, and, for example, determine the control condition every predetermined period. Then, every time the control condition is determined, the control of the following operation and beyond can be performed under the determined control condition.

FIG. 6 is a block diagram showing the determination system 100 according to another embodiment. The secondary battery 210 being the control target of the determination system 100 shown in FIG. 6 includes multiple unit secondary batteries 211 connected to one another. The unit secondary batteries 211 are, for example, battery cells, battery modules, battery packs, battery systems, or the like, and are battery modules in the shown example. Note that, although multiple unit secondary batteries 211 are connected to one determination system 100 in the example of FIG. 6, one determination system 100 may be connected to each unit secondary battery 211.

Moreover, in the determination system 100 shown in FIG. 6, the control unit 17 (FIG. 1) performs control that varies from the unit secondary battery 211 to the unit secondary battery 211. Accordingly, although the unit secondary batteries 211 in the secondary battery 210 may all be unit secondary batteries 211 in a state with similar characteristics (for example, brand-new batteries), the secondary battery 210 preferably includes at least one degraded unit secondary battery 211 (example of the secondary battery. For example, the second-hand secondary battery). The brand-new unit secondary battery 211 and the degraded unit secondary battery 211 are used in parallel in some cases depending on an operation of the battery system 300. The battery abnormality in each unit secondary battery 211 can be suppressed also in such a case by performing control that varies from the unit secondary battery 211 to the unit secondary battery 211.

First, the control condition in which occurrence of the battery abnormality is suppressed is determined for each unit secondary battery 211 by the method explained with reference to FIGs. 1 to 5 described above. Specifically, in the determination system 100 shown in FIG. 6, the calculating unit 15 calculates the spectrum information for each unit secondary battery 211. The determining unit 16 determines the control condition for each unit secondary battery 211. The determined control condition is recorded in the recording unit 12 for each unit secondary battery 211.

In the case where multiple unit secondary batteries 211 are connected to one another, levels of degradation of the respective unit secondary batteries 211 may vary due to charging-discharging to the entire secondary battery 210. Accordingly, the current value, the voltage value, and the temperature at which the battery abnormality does not occur may vary among the unit secondary batteries 211. The determining unit 16 thus determines the control condition in which occurrence of the battery abnormality is suppressed for each unit secondary battery 211, and determines the control condition in which the battery abnormality does not occur in all unit secondary batteries 211. This can suppress occurrence of the battery abnormality in each of the unit secondary batteries 211.

As described above, the power consuming equipment 400 (FIG. 1) such as, for example, a motor or an inverter is connected to the secondary battery 210. The current value, the voltage value, and the temperature at which the power consuming equipment 400 is used can be assumed to some extent depending on the application of the power consuming equipment 400 and the like. Accordingly, for each unit secondary battery 211, the determining unit 16 determines whether the current value, the voltage value, and the temperature expected to be used by the power consuming equipment 400 are within ranges of the control condition determined for the unit secondary battery 211. When at least one of the current value, the voltage value, or the temperature expected to be used (expected to be supplied) deviates from the determined control condition as a result of the determination, the determining unit 16 limits the deviating current value, the voltage value, or the temperature such that it fits into the corresponding range of the determined control condition. For example, the limiting can be executed such that the current value, the voltage value, and the temperature expected to be supplied are set to upper limit values of the respective ranges of the determined control condition for each unit secondary battery 211. Moreover, the control conditions of the respective unit secondary batteries 211 may be limited to a control condition common to all unit secondary batteries 211. After the determination and the appropriate limiting described above are performed for every unit secondary battery 211, power is supplied from the secondary battery 210 to the power consuming equipment 400.

Note that, although the discharging to the power consuming equipment 400 is explained in this example, the determination and the appropriate limiting may be performed also in the charging by the power supply 500.

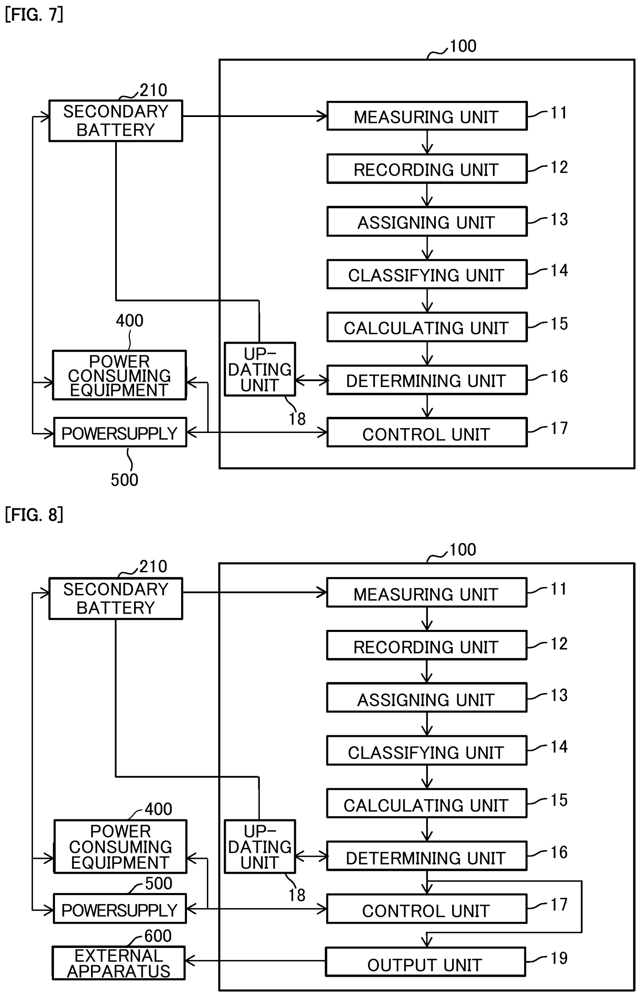

FIG. 7 is a block diagram showing the determination system 100 according to another embodiment. The secondary battery 210 that is the control target of the determination system 100 shown in FIG. 7 includes multiple unit secondary batteries 211 connected to one another as in FIG. 6 described above.

The determination system 100 shown in FIG. 7 further includes an updating unit 18 in the determination system 100 shown FIG. 1 described above. When at least one of the current value, the current value, or the temperature changes during the charging-discharging control of the secondary battery 210 by the control unit 17, the updating unit 18 causes the determining unit 16 to redetermine the control condition for each unit secondary battery 211, and updates the control condition used by the control unit 17 to the determined control condition. Providing the updating unit 18 enables suppression of the battery abnormality of the unit secondary batteries 211 also when the states of the unit secondary batteries 211 change in an actual operation.

The updating unit 18 may monitor, for example, at least one of the current value, the current value, or the temperature constantly or, for example, every predetermined time (for example, every one minute).

FIG. 8 is a block diagram showing the determination system 100 according to another embodiment. The determination system 100 shown in FIG. 8 further includes an output unit 19 in the determination system 100 shown in FIG. 1 described above. The output unit 19 is a unit that outputs the determination result obtained by the determination system 100 to an external apparatus 600. The outputted determination result may be, for example, the determined control condition, the map explained with reference to, for example, FIG. 2 described above, or at least one of the multiple relaxation spectra included in this map. Moreover, the outputted determination result may be information such as a graph or a function obtained by converting the determination result (for example, the determined control condition) obtained by the determination system 100 to a form of the graph explained with reference to FIG. 17 described above.

For example, the external apparatus 600 may be a display device (display, monitor, or the like), an external storage device such as an HDD, or an external cooperating apparatus that is provided independently from the determination system 100 and that operates in cooperation with the determination system 100..

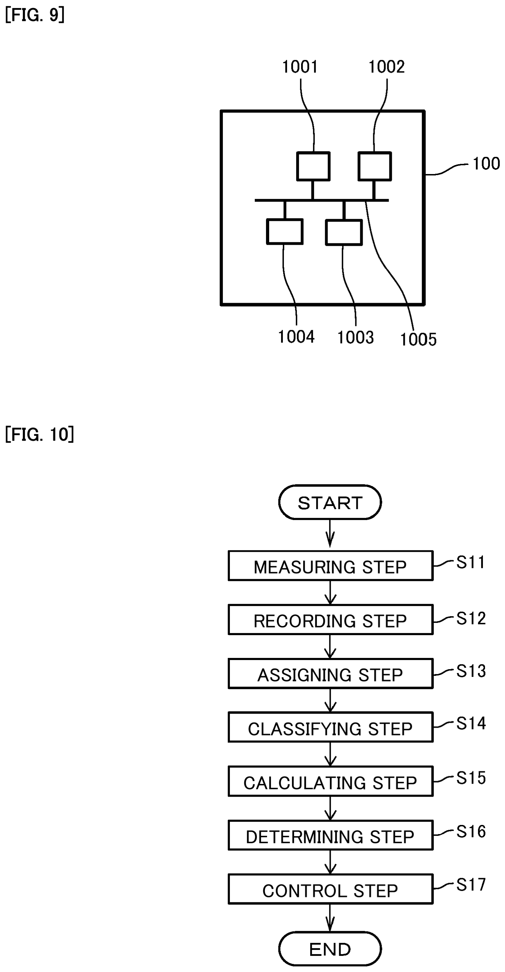

FIG. 9 is a block diagram showing a hardware configuration of the determination system 100. The determination system 100 is configured to include, for example, a CPU (central processing unit) 1001, a RAM (random access memory) 1002, a ROM (read only memory) 1003, an I/F (interface) 1004, a bus 1005, and the like. For example, the CPU 1001, the RAM 1002, the ROM 1003, and the I/F 1004 are connected to one another via the bus 1005. The CPU 1001 loads a predetermined control program (for example, the determination method of the present disclosure) stored in the ROM 1003 onto the RAM 1002 and executes the control program to implement the determination system 100. Exchange of signals and information between the determination system 100 and each of various devices (server and the like), external networks, and the like is performed through the I/F 1004 in terms of hardware.

FIG. 10 is a flowchart showing the determination method of the present disclosure. The determination method of the present disclosure can be executed by, for example, the determination system 100 shown in FIG. 1 described above. Accordingly, the matters explained for the determination system 100 can be similarly applied to the determination method of the present disclosure.

The determination method of the present disclosure includes a measuring step S11, a recording step S12, an assigning step S13, a classifying step S14, a calculating step S15, a determining step S16, and a control step S17.

The measuring unit 11 is a step of measuring the time series data of each of values including the DC current value and at least one of the DC voltage value or the SOC of the secondary battery 210 during the charging-discharging that is at least one of the charging or the discharging of the secondary battery 210. The measuring step S11 may be executed by, for example, the measuring unit 11 (FIG. 1). The recording step S12 is a step of saving the measurement data (data including the above-mentioned time series data, the voltage value before the start of charging, the current value immediately before the charging-discharging, and the like) of the secondary battery 210 extracted in the measuring step S11. The recording step S12 may be executed by, for example the recording unit 12 (FIG. 1).

The assigning step S13 is a step of assigning the label to each spectrum calculated from the time series data obtained between different time points, according to the predetermined rule using at least two of the DC current value, the DC voltage value, or the temperature. The assigning step S13 may be executed by, for example, the assigning unit 13 (FIG. 1). The classifying step S14 is a step of classifying the relaxation spectra to which the labels are assigned, according to the assigned labels, such that the relaxation spectra are associated with the conditions of at least two of the current value (DC current value), the voltage value (DC voltage value), or the temperature. The classifying step S14 may be executed by, for example, the classifying unit 14 (Fig 1).

The calculating step S15 is a step of calculating the spectrum information expressing each of the above-mentioned relaxation spectra (example of spectra). The calculating step S15 may be executed by, for example, the calculating unit 15 (FIG. 1). The determining step S16 is a step of determining the control condition of the secondary battery 210 by using the shape information relating to the shapes of the relaxation spectra calculated in the calculating step S15. The determining step S16 may be executed by, for example, the determining unit 16 (FIG. 1).

The control step S17 is a step of performing the charging-discharging control of the secondary battery 210 according to the control condition of the secondary battery 210 determined in the determining step S16. The control step S17 may be executed by, for example, the control unit 17 (FIG. 1).

**Examples**

The present disclosure is more specifically explained below by giving examples.

Evaluation tests were actually performed for identification of the occurrence condition of the battery abnormality using the determination system 100 and for control of the secondary battery 210 using the determination system 100.

A cylindrical lithium-ion secondary battery (example of the secondary battery 210) with a battery capacity of 5 Ah was used for verification. A positive electrode (electrode 50 to be described later) was formed by applying $LiNiMnCoO_2$ to a metal current collector as a positive electrode active material, and a negative electrode was formed of carbon. The time series data of each of the current value, the voltage value, and the temperature during usage of the secondary battery 210 was used as the measurement data for calculating the relaxation spectra. Moreover, multiple pieces of time series data during the constant voltage charging were extracted, and the representative value of each of the current value and the temperature and the relaxation spectra were calculated from the extracted time series data.

Sections of representative value of the current value were sections of 0 A to 25 A, 25 to 50A, 50 to 75 A, 75 A to 100 A, and 100 A to 125 A. Sections of the representative value of the temperature where sections of 0 to 10°C, 10°C to 25°C, 25°C to 35°C, and 35°C to 45°C. Then, the representative values were classified according to these sections.

Next, the relaxation spectrum was calculated by using the time series data classified into each section. In this case, if multiple pieces of time series data obtained at different timings were included in each section, the time series data obtained at the latest timing was used to calculate the relaxation spectrum. For example, if a section designated as the current value 0 A to 25 A and the temperature 0°C to 10°C included two types of time series data obtained from a time point tA to a time point tB and from a time point tC to a time point tD (note that tB<tC), the relaxation spectrum was calculated by using the time series data obtained from the time point tC to the time point tD.

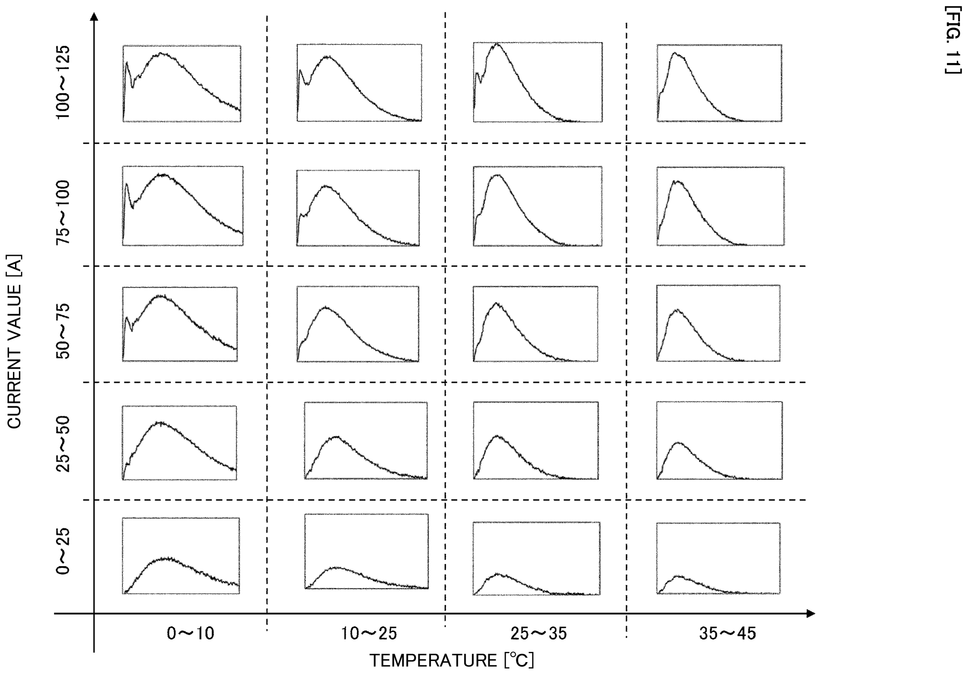

FIG. 11 is a map that is obtained by actually performing the evaluation tests and that is used to obtain the occurrence condition of the battery abnormality from the relaxation spectra. The occurrence condition of the battery abnormality was identified by focusing on the shape information of the obtained relaxation spectra in the map shown in FIG. 11. In this case, the number of peaks was used as the shape information of the relaxation spectra. The reason for this is as follows. The shape information of the relaxation spectra corresponds to the reaction mode inside the battery, and an increase in the number of peaks on the relaxation spectrum particularly indicates occurrence of an abnormal reaction mode inside the battery as described above.

FIG. 12 is a map that is obtained by actually performing evaluation tests and in which a range in which the battery abnormality occurs is excluded. A hatched range is the second range R2 described above, and a range that is not hatched are the first range R1 described above. The relaxation spectra in the second range R2 are relaxation spectra present in sections in which the temperature is 0°C to 10°C and the current value is 50 A to 125 A, the temperature is 10°C to 25°C and the current value is 75 A to 125 A, and the temperature is 25°C to 35°C and the current value is 100 A to 125 A. The relaxation spectra in the first range R1 are relaxation spectra present in sections in which the temperature is 0°C to 10°C and the current value is 0 A to 50 A, the temperature is 10°C to 25°C and the current value is 0 A to 75 A, the temperature is 25°C to 35°C and the current value is 0 A to 100 A, and the temperature is 35°C to 45°C and the current value is 0 A to 125 A.

In comparison between the relaxation spectra in the hatched second range R2 and the relaxation spectra in the not-hatched first range R1, the number of peaks in the hatched relaxation spectra is two, while the number of peaks in the not-hatched relaxation spectra is one. Accordingly, occurrence of an abnormal reaction mode inside the battery is indicated in the second range R2 of the hatched relaxation spectra. Thus, occurrence of the battery abnormality can be assumed to be suppressed by controlling the current value and the temperature of the secondary battery 210 to avoid usage of the secondary battery 210 as much as possible in the temperature and current value conditions corresponding to the hatched first range R1.

Moreover, in order to verify the effects of the present disclosure, whether the battery abnormality occurred or not was verified in the case (Condition 1. Example) where the control was performed to avoid usage in the temperature and current value conditions corresponding to the relaxation spectra hatched in FIG. 9 and in the case (Condition 2. Comparative Example) where the control was performed to continue usage of the secondary battery intensively in these temperature and current value conditions. In the verification, the secondary batteries 210 used for about four months in Condition 1 and Condition 2 were disassembled, and whether abnormality occurred on the electrode of each secondary battery 210 was checked.

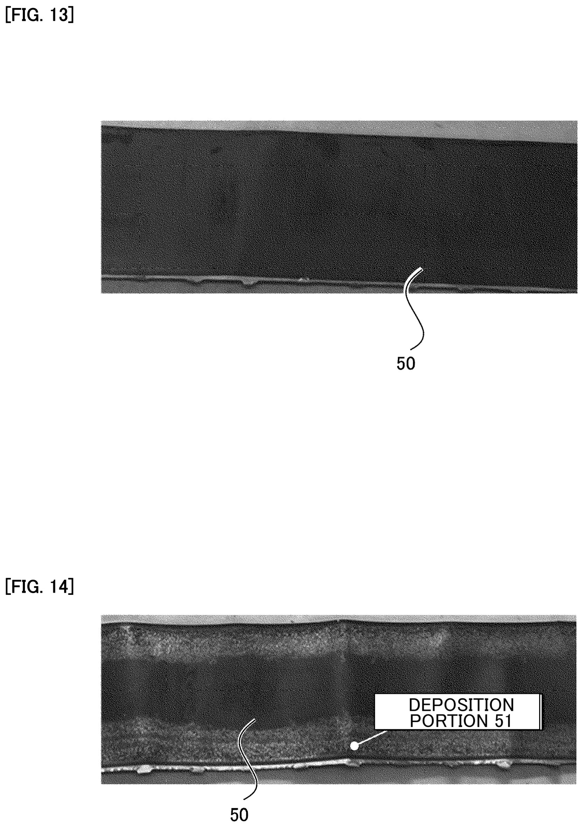

FIG. 13 is a photograph capturing a surface of the electrode 50 of the secondary battery 210 (FIG. 1) used in Condition 1 (Example). As shown in FIG. 13, the surface of the electrode 50 had a uniform outer appearance, and no abnormality was confirmed on the surface of the electrode 50.

FIG. 14 is a photograph capturing the surface of the electrode 50 of the secondary battery 210 (FIG. 1) used in Condition 2 (Comparative Example). As shown in FIG. 14, a strip-shaped deposition portion 51 in which lithium deposition abnormality occurred was confirmed on the surface of the electrode 50. Accordingly, it was confirmed that the determination system 100 of the present disclosure can suppress occurrence of the battery abnormality.

As another comparative example, a method using an AC impedance method stated in Patent Literature 1 described above was also performed. However, measurement of the time series data of the current value and the voltage value of the secondary battery 210 was impossible. The reason is that a large current of about 100 A at maximum was applied to the secondary 210 to obtain the results of FIGs. 11 and 12 described above, but the voltage value reached an overvoltage value in the application of the AC current value, and the measurement was impossible. As described above, the results shown in FIGs. 11 and 12 described above can be obtained only by using the DC current value and the DC voltage value, and it is found that the present disclosure is more substantial than the invention described in Patent Literature 1.

Next, as another evaluation, a point that the present disclosure is effective as a control method that suppresses degradation of the secondary battery 210 and that enables use of the secondary battery 210 while achieving longevity was verified. In the verification, the secondary batteries 210 were used according to Condition 1 and Condition 2 determined in FIGs. 11 and 12 described above, and degradation states after the usage were compared. Specifically, how much the battery capacity and the internal resistance of each secondary battery 210 degraded from a brand-new state after usage of about four months were measured.

FIG. 15 is a verification result showing a difference in the battery capacity between the secondary battery 210 used in Condition 1 (Example) and the secondary battery 210 used in Condition 2 (Comparative Example). In FIG. 15 and FIG. 16 to be described later, relative values are shown with the battery capacity and the internal resistance in the brand-new (undegraded) secondary battery 210 being 100%. Moreover, the numerical values described above the bar graphs in FIG. 15 and FIG. 16 to be described later are numerical values based on which the bar graphs shown below the numerical values are created. In FIG. 15, the vertical axis is a capacity maintaining ratio (%).

As shown in FIG. 15, in Condition 1 (Example), the battery capacity only slightly decreased after usage of about four months (95.6%). Meanwhile, in Condition 2 (Comparative Example), the battery capacity greatly decreased by usage of about four months, and decreased to about 75% of the battery capacity in the brand-new secondary battery 210 (75.1%). As described above, it is found that performing the control in Condition 1 can suppress a decrease of the battery capacity caused by degradation of the secondary battery 210.

FIG. 16 is a verification result showing a difference in the internal resistance between the secondary battery 210 used in Condition 1 (Example) and the secondary battery 210 used in Condition 2 (Comparative Example). In FIG. 16, the vertical axis is a resistance maintaining ratio (%).

As shown in FIG. 16, in Condition 1 (Example), the internal resistance only slightly increased after usage of about four months (107.4%). Meanwhile, in Condition 2 (Comparative Example), the internal resistance significantly increased by usage of about four months, and increased to about 1.9 times the internal resistance in the brand-new secondary battery 210 (187.1%). As described above, it is found that performing the control in Condition 1 can suppress an increase of the internal resistance caused by degradation of the secondary battery 210.

As shown in FIGs. 15 and 16 described above, using the determination system 100 enables execution of charging-discharging in which a significant decrease of the battery capacity and a significant increase of the internal resistance are avoided. The present disclosure is thereby effective for suppression of degradation of the secondary battery 210, and can achieve longevity of the secondary battery 210.

Reference Signs List

| | |
|---|---|
| 100 | determination system |
| 11 | measuring unit |
| 12 | recording unit |
| 13 | assigning unit |
| 14 | classifying unit |
| 15 | calculating unit |
| 16 | determining unit |
| 17 | control unit |
| 18 | updating unit |
| 200 | relaxation spectrum |
| 201 | peak |
| 202 | peak |
| 210 | secondary battery |
| 211 | unit secondary battery |
| 300 | battery system |
| S11 | measuring step |
| S12 | recording step |
| S13 | assigning step |
| S14 | classifying step |
| S15 | calculating step |
| S16 | determining step |
| S17 | control step |

**Claims**

1. A determination system comprising:

a calculating unit configured to calculate spectrum information expressing spectra in a two-axis coordinate system in which one axis represents a relaxation time and the other axis represents an intensity, from time series data of each of values including a DC current value and at least one of a DC voltage value or a SOC of a secondary battery in charging-discharging that is at least one of charging or discharging of the secondary battery; and
a determining unit configured to determine a control condition of the secondary battery by using shape information relating to shapes of the spectra calculated by the calculating unit.

2.  The determination system according to claim 1, wherein the shape information includes at least one of the number of peaks in each of the spectra, a position of the peak, an area of the peak, a half-value width of the peak, or a skewness of the peak.

3.  The determination system according to claim 1, wherein the calculating unit calculates the spectra from the time series data in each of at least one of periods including during constant voltage charging, after charging, or after discharging.

4.  The determination system according to claim 1, wherein

     the time series data includes time series data of a temperature of the secondary battery, and
     the spectra are associated with the temperature of the secondary battery.

5.  The determination system according to claim 1, further comprising:

     an assigning unit configured to assign a label to each of the spectra calculated from the time series data obtained between different time points, according to a predetermined rule using at least two of the DC current value, the DC voltage value, or a temperature, and
     a classifying unit configured to classify the spectra to which the labels are assigned, according to the assigned labels such that the spectra are associated with conditions of at least two of the DC current value, the DC voltage value, or the temperature.

6.  The determination system according to claim 5, wherein

     the conditions are each configured to include a plurality of numerical value ranges, and
     one of the spectra is associated with one of the numerical value ranges.

7.  The determination system according to claim 5, wherein

     the spectra include a first relaxation spectrum calculated from the time series data from a first time point to a second time point and a second relaxation spectrum calculated from the time series data from a third time point to a fourth time point, and
     the determining unit determines the control condition based a shape change from the first relaxation spectrum to the second relaxation spectrum.

8.  The determination system according to claim 7, wherein

     the shape information on the shapes includes quantifiable indices, and
     the determining unit

         determines that battery abnormality occurs in the secondary battery when the shapes change such that the indices change in a positive direction, and
         determines the control condition such that changes for which the battery abnormality is determined to occur in the secondary battery are excluded.

9.  The determination system according to claim 7, wherein the determining unit determines a DC current value lower than an abnormal DC current value corresponding to the spectrum for which battery abnormality is determined to occur in the secondary battery, a DC voltage value lower than an abnormal DC voltage value corresponding to the spectrum, and a temperature value lower than an abnormal temperature corresponding to the spectrum, as the control condition.

10. The determination system according to claim 1, wherein the secondary battery includes a degraded secondary battery.

11. The determination system according to claim 1, wherein the secondary battery includes a plurality of unit secondary batteries connected to each other.

12. The determination system according to claim 11, wherein

the calculating unit calculates the spectrum information for each of the unit secondary batteries, and
the determining unit determines the control condition for each of the unit secondary batteries.

13. The determination system according to claim 11, further comprising

a control unit configured to control the charging-discharging of the secondary battery according to the determined control condition of the secondary battery, and
an updating unit configured to cause the determining unit to redetermine the control condition for each of the unit secondary batteries when at least one of the DC current value, the DC current value, or a temperature changes during the charging-discharging control of the secondary battery by the control unit, and to update the control condition used by the control unit to the determined control condition.

14. The determination system according to claim 1, further comprising a measuring unit configured to measure data relating to the secondary battery at a location different from an installed location of the secondary battery.

15. A determination method comprising:

a calculation step of calculating spectrum information expressing spectra in a two-axis coordinate system in which one axis represents a relaxation time and the other axis represents an intensity, from time series data of each of values including a DC current value and at least one of a DC voltage value or a SOC of a secondary battery in charging-discharging that is at least one of charging or discharging of the secondary battery; and
a determining step of determining a control condition of the secondary battery by using shape information relating to shapes of the spectra calculated in the calculating step.

[FIG. 1]

[FIG. 2]

[FIG. 3]

[FIG. 4]

EP 4 729 961 A1

[FIG. 5]

[FIG. 6]

[FIG. 7]

[FIG. 8]

[FIG. 9]

[FIG. 10]

[FIG. 11]

[FIG. 12]

EP 4 729 961 A1

[FIG. 13]

50

[FIG. 14]

DEPOSITION
PORTION 51

50

26

[FIG. 15]

CAPACITY MAINTAINING RATIO [%]

95.6%

75.1%

CONDITION 1 (EXAMPLE)   CONDITION 2 (COMPARATIVE EXAMPLE)

[FIG. 16]

RESISTANCE INCREASE RATIO [%]

187.1%

107.4%

CONDITION 1 (EXAMPLE)   CONDITION 2 (COMPARATIVE EXAMPLE)

[FIG. 17]

CURRENT VALUE

S

f

TEMPERATURE

## INTERNATIONAL SEARCH REPORT

International application No.

**PCT/JP2024/016090**

### A. CLASSIFICATION OF SUBJECT MATTER

*G01R 31/382*(2019.01)i; *G01R 31/00*(2006.01)i; *H01M 10/48*(2006.01)i
FI:   G01R31/382; G01R31/00; H01M10/48 P

According to International Patent Classification (IPC) or to both national classification and IPC

### B. FIELDS SEARCHED

Minimum documentation searched (classification system followed by classification symbols)

G01R31/382; G01R31/00; H01M10/48

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2020/022124 A1 (NATIONAL INSTITUTE FOR MATERIALS SCIENCE) 30 January 2020 (2020-01-30)<br>entire text, all drawings | 1-15 |
| A | WO 2017/179266 A1 (SONY CORPORATION) 19 October 2017 (2017-10-19)<br>entire text, all drawings | 1-15 |
| A | US 2022/0011373 A1 (ZAPPEN, Hendrik) 13 January 2022 (2022-01-13)<br>entire text, all drawings | 1-15 |
| A | US 2011/0285356 A1 (MALUF, Nadim) 24 November 2011 (2011-11-24)<br>entire text, all drawings | 1-15 |
| A | CN 114114047 A (HUAWEI TECHNOLOGY CO., LTD.) 01 March 2022 (2022-03-01)<br>entire text, all drawings | 1-15 |

☑ Further documents are listed in the continuation of Box C.      ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **19 June 2024** | **02 July 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**EP 4 729 961 A1**

## INTERNATIONAL SEARCH REPORT

<table>
<tr><td colspan="3">International application No.<br>**PCT/JP2024/016090**</td></tr>
</table>

**C.    DOCUMENTS CONSIDERED TO BE RELEVANT**

| Category* | Citation of document, with indication, where appropriate, of the relevant passages | Relevant to claim No. |
|---|---|---|
| A | CN 110501656 A (ZHONGTIAN ENERGY STORAGE TECHNOLOGY CO., LTD.) 26 November 2019 (2019-11-26)<br>entire text, all drawings | 1-15 |

Form PCT/ISA/210 (second sheet) (July 2022)

## INTERNATIONAL SEARCH REPORT
### Information on patent family members

International application No.

**PCT/JP2024/016090**

| Patent document cited in search report | | | Publication date (day/month/year) | Patent family member(s) | | | Publication date (day/month/year) |
|---|---|---|---|---|---|---|---|
| WO | 2020/022124 | A1 | 30 January 2020 | US | 2021/0293867 | A1 | |
| | | | | entire text, all drawings | | | |
| | | | | EP | 3848713 | A1 | |
| WO | 2017/179266 | A1 | 19 October 2017 | US | 2019/0023131 | A1 | |
| | | | | entire text, all drawings | | | |
| US | 2022/0011373 | A1 | 13 January 2022 | WO | 2020/064932 | A1 | |
| | | | | entire text, all drawings | | | |
| | | | | DE | 102018216517 | A1 | |
| | | | | CN | 113196072 | A | |
| US | 2011/0285356 | A1 | 24 November 2011 | WO | 2011/146783 | A1 | |
| | | | | entire text, all drawings | | | |
| | | | | CN | 102906961 | A | |
| | | | | KR | 10-2013-0120378 | A | |
| CN | 114114047 | A | 01 March 2022 | (Family: none) | | | |
| CN | 110501656 | A | 26 November 2019 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2017179266 A